# EUROPEAN PATENT APPLICATION

(11) **EP 4 546 403 A1**
(43) Date of publication of application: **30.04.2025**
(21) Application number: 23827380.9
(22) Date of filing: 19.05.2023
(51) Int. Cl.: H01L 21/67, H01L 21/677, H01L 21/687, B25J 11/00, B25J 13/08

(54) **SUBSTRATE TRANSFER APPARATUS AND OPERATION METHOD THEREOF**

(30) Priority: 21.06.2022 KR 20220075791
(71) Applicant: Eugene Technology Co., Ltd., Yongin-si, Gyeonggi-do 17156 (KR)
(72) Inventor: BAE, Hyeong Hwan, Yongin-si, Gyeonggi-do 17026 (KR); SONG, Byoung Gyu, Yongin-si, Gyeonggi-do 17129 (KR); MIN, Jung Ki, Yongin-si, Gyeonggi-do 17045 (KR); KO, Hyeong Sik, Yongin-si, Gyeonggi-do 17161 (KR)
(74) Representative: Michalski Hüttermann & Partner Patentanwälte mbB
(86) International application number: PCT/KR2023/006840
(87) International publication number: WO 2023/249260

(57) **Abstract**

The present invention relates to a substrate transfer apparatus detecting a collision of an end-effector, and an operation method thereof. The substrate transfer apparatus comprises: an end-effector for supporting a substrate; a motor for providing power for moving the end-effector; a collision detection unit for detecting a collision of the end-effector; and a control unit for controlling the driving of the motor according to the collision detection of the collision detection unit. The collision detection unit may comprise: a torque measurement unit for measuring a torque value of the motor; a difference value calculation unit for calculating a torque difference value between two torque measurement values measured with a time lag therebetween; and a collision determination unit for determining a collision of the end-effector on the basis of the torque difference value.

## Description

### TECHNICAL FIELD

The present invention relates to a substrate transfer apparatus and an operation method of the substrate transfer apparatus, and more particularly, to a substrate transfer apparatus for detecting collision of an end-effector, and an operation method thereof.

### BACKGROUND ART

To perform various unit processes such as deposition, etching, and cleaning in the semiconductor and display manufacturing process, a plurality of apparatuses that are suitable for each process characteristic are provided, and each of the different types of apparatuses is provided with a substrate transfer apparatus for transferring a substrate such as a wafer.

In general, a substrate transfer apparatus in a semiconductor facility serves to transfer a substrate from a load-lock chamber to a substrate accommodation member (e.g., FOUP, carrier, etc.) or from the substrate accommodation member to the load-lock chamber.

The substrate transfer apparatus perform mechanical movement using power provided from a motor and operate within a specified movement range. Collision with an obstacle may occur due to a case in which a substrate is out of a set position, or an end-effector of the substrate transfer apparatus is not in a correct position during movement within the region, or a reason such as an error in transfer program, resulting in damage to the substrate transfer apparatus and/or the collision target (or obstacle) or defect in substrate.
(Patent Document 1) Korean Patent Publication No. 10-2020-0130058

### DISCLOSURE OF THE INVENTION

### TECHNICAL PROBLEM

The present invention provides a substrate transfer apparatus that detects collision of an end-effector to protect the end-effector, a collision target and/or a substrate, and an operation method of the substrate transfer apparatus.

### TECHNICAL SOLUTION

A substrate transfer apparatus according to an embodiment of the present invention includes: an end-effector on which a substrate is supported; a motor configured to provide power for movement of the end-effector; a collision detection unit configured to detect collision of the end-effector; and a control unit configured to control driving of the motor depending on the collision detection of the collision detection unit, wherein the collision detection unit includes: a torque measurement part configured to measure a torque value of the motor; a difference value calculation part configured to calculate a torque difference value between two torque measurement values measured with a time difference; and a collision determination part configured to determine the collision of the end-effector based on the torque difference value.

The collision detection unit may further include a reference value setting part configured to set a collision determination reference value, wherein the collision determination part may be configured to determine that the end-effector has collided when the torque difference value is equal to or greater than the collision determination reference value, and the control unit may be configured to stop the driving of the motor or drive the motor in a reverse direction when the collision determination part determines that the end-effector has collided.

The collision detection unit may further include a measurement position storage part configured to record a measurement position of the torque value, wherein the control unit may be configured to stop the driving of the motor after driving the motor to a previous measurement position.

The collision detection unit may further include a measurement value storage part configured to store the measured torque value of the motor, wherein the torque measurement part may be configured to measure the torque value of the motor at a predetermined period, and the difference value calculation part may be configured to calculate a torque difference value between a current period torque measurement value and a proximate period torque measurement value for each of the predetermined periods.

The driving of the motor may include: acceleration driving for increasing in torque of the motor; constant speed driving for maintaining the torque of the motor within a predetermined deviation; and deceleration driving for decreasing in torque of the motor, wherein the substrate transfer apparatus may further include an acceleration time setting unit configured to set an acceleration driving time.

The reference value setting part may be configured to set the collision determination reference value depending on a rate of change in the torque value of the motor with respect to the set acceleration driving time.

The collision detection unit may further include a measurement period setting part configured to set a measurement period of the torque value of the motor according to the set acceleration driving time, wherein the measurement period setting part may be configured to set the measurement period of the torque value of the motor to be shorter than the set acceleration driving time.

The torque measurement part may be configured to measure the torque value of the motor at least twice during the acceleration driving.

The torque measurement part may be configured to measure the torque value of the motor at least at a starting point of the acceleration driving.

An operation method of a substrate transfer apparatus according to another embodiment of the present invention includes: moving an end-effector on which a substrate is supported by providing power through a motor; measuring a torque value of the motor several times with a time difference; calculating a torque difference value between two measured torque measurement values; and determining collision of the end-effector based on the calculated torque difference value.

The operation method may further include: setting a collision determination reference value; and stopping the driving of the motor or driving the motor in a reverse direction when it is determined that the end-effector has collided in the determining the collision of the end-effector, wherein, in the determining the collision of the end-effector, it may be determined that the end-effector has collided when the calculated torque difference value is equal to or greater than the set collision determination reference value.

The operation method may further include recording a measurement position of the torque value, wherein the stopping the driving of the motor or the driving the motor in the reverse direction may include stopping the driving of the motor after driving the motor to a previous measurement position.

The operation method may further include storing the measured torque value of the motor, wherein, in the measuring the torque value of the motor, the torque value of the motor may be measured at a predetermined period, and in the calculating the torque difference value, a torque difference value between a current period torque measurement value and a proximate period torque measurement value may be measured for each of the predetermined periods.

The moving the end-effector may include: an acceleration process of increasing in torque of the motor; a constant speed process of maintaining the torque of the motor within a predetermined deviation; and a deceleration process of decreasing in torque of the motor, wherein the operation method may further include setting a time for the acceleration process.

In the setting the reference value, the collision determination reference value may be set depending on a rate of change in the torque value of the motor with respect to the set time of the acceleration process.

The operation method may further include setting a measurement period of the torque value of the motor according to the set time of the acceleration process, wherein, in the setting the measurement period, the measurement period of the torque value of the motor may be set to be shorter than the set time of the acceleration process.

In the measuring the torque value of the motor, the torque value of the motor may be measured at least twice in the acceleration process.

In the measuring the torque value of the motor, the torque value of the motor may be measured at least at a starting point in the acceleration process.

### ADVANTAGEOUS EFFECTS

The substrate transfer apparatus according to the embodiments of the present invention may effectively detect the collision of the end-effector by calculating the torque difference value between the two torque measurement values measured with a time difference through the collision detection unit and determining the collision of the end-effector based on the calculated torque difference value, to stop the motor or rotate the motor in the reverse direction, thereby minimizing the damage caused by the collision of the end-effector.

That is, the collision of the end-effector may be determined using the change in torque over time (or per unit time) through the two torque measurement values measured with the time difference rather than the absolute amount (or absolute value) of the torque to detect the collision of the end-effector regardless of the movement speed and movement distance of the end-effector and also effectively detect the collision of the end-effector both the case, in which the end-effector is moving while being accelerated or decelerated and the case, in which the end-effector is moving at the constant speed so that there is no need to differentiate the collision determination reference that is segmented according to the movement speed and movement distance of the end-effector.

### BRIEF DESCRIPTION OF THE DRAWINGS

FIG. 1 is a schematic view of a substrate transfer apparatus according to an embodiment of the present invention.
FIG. 2 is a graph illustrating torque measurement values for each period and a proximate period torque measurement value for each period according to an embodiment of the present invention.
FIG. 3 is a conceptual view for explaining calculation of a torque difference value according to an embodiment of the present invention.
FIG. 4 is a flowchart illustrating an operation method of a substrate transfer apparatus according to another embodiment of the present invention.

### MODE FOR CARRYING OUT THE INVENTION

Hereinafter, specific embodiments will be described in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. In the descriptions, the same elements are denoted with the same reference numerals. In the figures, the dimensions of layers and regions are exaggerated for clarity of illustration. Like reference numerals refer to like elements throughout.

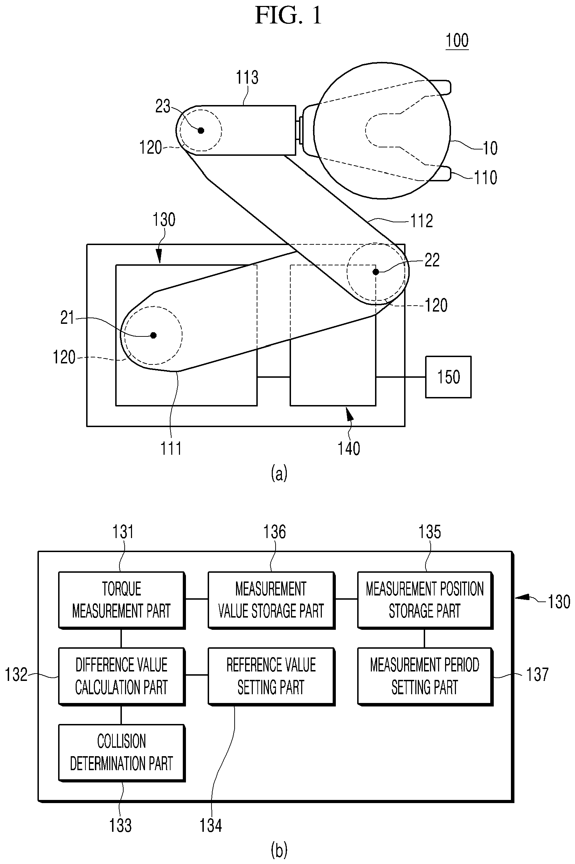

FIG. 1 is a schematic view of a substrate transfer apparatus according to an embodiment, (a) of FIG. 1 is a plan view of the substrate transfer apparatus, and (b) of FIG. 1 is a block diagram of a collision detection unit.

Referring to FIG. 1, a substrate transfer apparatus 100 according to an embodiment may include an end-effector 110 on which a substrate 10 is supported, a motor 120 that provides power for movement of the end-effector 110, a collision detection unit 130 that detects collision of the end-effector 110, and a control unit 140 that controls driving of the motor 120 according to the collision detection of the collision detection unit 130.

The end-effector 110 may support the substrate 10 and extend in a first direction. For example, the end-effector 110 may have a fork shape including a plurality of fingers disposed (or arranged) in a second direction intersecting the first direction in parallel to the first direction and may support the substrate 10 by being in contact with a bottom surface of the substrate 10. Here, the second direction may be a direction intersecting the first direction in horizontal directions, and when the first direction is a forward and backward direction, the second direction may be a left and right direction. In addition, the end-effector 110 may be made of a ceramic material such as quartz, aluminum oxide (Al₂O₃), aluminum nitride (AlN), silicon carbide (SiC), titanium dioxide (TiO₂), and silicon dioxide (SiO2). Here, the substrate 10 may be a wafer, but is not particularly limited thereto, and may also be a glass substrate, etc.

The end-effector 110 may be provided in plurality and disposed (or stacked) in multiple stages (or in a third direction intersecting both the first direction and the second direction), and the substrate 10 may be supported on each stage (i.e., each of the plurality of end-effectors) so that two or more substrates 10 corresponding to the number of end-effectors 110 are transferred at once.

The motor 120 may provide the power for the movement of the end-effector 110 and may move the end-effector 110 through mechanical movement of arms 111, 112, and 113 connected to the end-effector 110 by the power. For example, the power may be provided to the arm 111, 112, and 113 through rotation of the rotation shafts 21, 22, and 23 of the motor 120, and a rotation speed of each of the rotation shafts 21, 22, and 23 may be controlled by the control unit 140. Here, as illustrated in (a) of FIG. 1, the end-effector 110 may move by connecting ends between the arms 111, 112, and 113 and performing joint movement due to the rotation of the rotation shafts 21, 22, and 23, or the end-effector 110 may move by moving the arm 113 to which the end-effector 110 is connected along a guide rail (not shown) by rotational force of the motor 120.

For example, in the case of the joint movement by the rotation of the rotation shafts 21, 22, and 23, the substrate transfer apparatus 100 according to the present invention may include three arms 111, 112, and 113 and three rotation shafts 21, 22, and 23. The first arm 111 has one end fixed (or connected) to the first rotation shaft 21 and may axially rotate around the first rotation shaft 21.

In addition, the second arm 112 may have one end connected to the other end of the first arm 111 by the second rotation shaft 22 and may axially rotate around the second rotation shaft 22.

In addition, the third arm 113 may have one end connected to the other end of the second arm 112 by the third rotation shaft 23 and the other end connected to the end-effector 110 and may axially rotate about the third rotation shaft 23.

The first arm 111, the second arm 112, and the third arm 113 may rotate about the first rotation shaft 21, the second rotation shaft 22, and the third rotation shaft 23, respectively, so that a position of the end-effector 110 is changed (or moved).

The collision detection unit 130 may detect collision of the end-effector 110 to transmit whether the collision has been detected to the control unit 140, thereby controlling the driving of the motor 120. For example, when the collision detection unit 130 detects the collision of the end-effector 110, the collision detection unit 130 may generate a collision detection signal to transmit the collision detection signal to the control unit 140.

The control unit 140 may control the driving of the motor 120 according to the collision detection of the collision detection unit 130 to control a rotation speed of each of the rotation shafts 21, 22, and 23. For example, when the collision detection signal is transmitted from the collision detection unit 130, the control unit 140 may generate a control signal for controlling the rotation speed of each of the rotation shafts 21, 22, and 23 to transmit the control signal to the motor 120.

Here, the collision detection unit 130 may include a torque measurement part 131 that measures a torque value of the motor 120, a difference value calculation part 132 that calculates a torque difference value D between two torque measurement values measured with a time difference, and a collision determination part 133 that determines the collision of the end-effector 110 based on the torque difference value D. The torque measurement part 131 may measure the torque value of the motor 120 and detect a speed of each of the rotation shafts 21, 22, and 23 of the motor 120 and/or a rotation angle of each of the rotation shafts 21, 22, and 23. For example, the torque measurement part 131 may include an encoder that detects the speed of each of the rotation shafts 21, 22, and 23 of the motor 120, the rotation angle of each of the rotation shafts 21, 22, and 23, or the rotation torque of each of the rotation shafts 21, 22, and 23, and a Tacho generator. Here, a value of current (or amount of current) supplied to the motor 120 when the motor 120 is driven may be converted into torque of the motor 120 to measure (or calculate) the torque value of the motor 120.

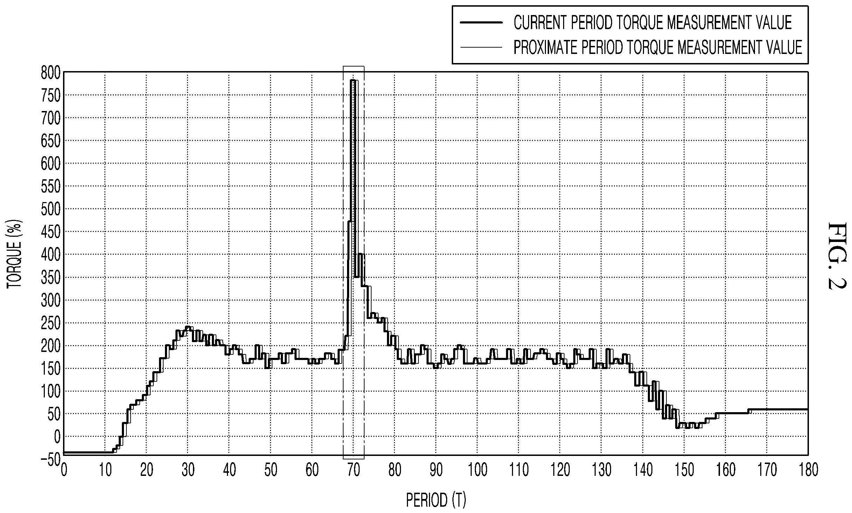

FIG. 2 is a graph illustrating (the current) torque measurement values for each period and a proximate period torque measurement value for each period according to an embodiment. Here, a dashed dotted line box indicates a point (or time point) at which the collision of the end-effector occurs.

Referring to FIG. 2, the difference value calculation part 132 may calculate a torque difference value D between two torque measurement values measured with a time difference and also may calculate a torque difference value D between the currently measured torque measurement value (or the current torque measurement value) and the torque measurement value (or the previous torque measurement value) measured before a predetermined period (a predetermined time). Here, the difference value calculation part 132 may calculate the torque difference value D in real time by subtracting (deducting) the torque measurement value measured before a predetermined time (i.e., the previous torque measurement value) from the torque measurement value measured in real time (i.e., the current torque measurement value) and may also express the torque difference value D as an absolute value.

The collision determination part 133 may determine the collision of the end-effector 110 based on the torque difference value D and may determine the collision of the end-effector 110 when the torque difference value D is greater than or equal to a critical torque difference value (or a collision determination reference value). That is, the collision determination part 133 may determine the collision of the end-effector 110 by comparing the torque difference value D obtained by subtracting (or deducting) the torque measurement value measured before the predetermined time from the torque measurement value measured in real time with the critical torque difference value, rather than comparing the torque measurement value measured in real time with the torque critical value.

In the related art, the torque value of the motor 120 was measured while moving the end-effector 110 in advance in the same manner as during the transfer (process) of the substrate transfer apparatus 100, and the torque critical value was set to be **1.5** to 2 times higher than the highest value (or maximum value) of the measured torque value(s) of the motor 120, and when the torque measurement value measured in real time during the transfer of the substrate transfer apparatus 100 exceeds the torque critical value, it was determined that the collision of the end-effector 110 occurred, and the driving of the motor 120 was stopped. In the related art, since the torque value of the motor 120 generated from acceleration driving of the motor 120 is (much) larger than the torque value of the motor 120 generated from constant speed driving of the motor 120, the torque critical value, which is larger than the torque value of the motor 120 generated from the acceleration driving of the motor 120, may become much larger than the torque measurement value (or the torque value of the motor generated from the constant speed driving of the motor) that is usually (or generally) measured from the constant speed driving of the motor 120, and thus, the difference between the torque critical value and the torque measurement value that is usually measured from the constant speed driving of the motor 120 may become very large, and it may be difficult to effectively detect the collision of the end-effector 110 that occurs from the constant speed driving of the motor 120.

To solve this limitation, the acceleration driving of the motor 120, the constant speed driving of the motor 120, and the deceleration driving of the motor 120 may be distinguished depending on the speed of each of the rotation shafts 21, 22, and 23 of the motor 120 (or the rotation speed of the rotation shaft), and the torque critical value may be designated (differently) for each driving (or each of the acceleration driving of the motor, the constant speed driving of the motor, and the deceleration driving of the motor). In this case, the time for each driving is different depending on the movement distance and/or movement speed of the end effector 110, and the maximum value of the torque value(s) of the torque value(s) of the motor 120 measured during the transfer (process) in each driving (particularly, the maximum value of the torque value of the motor measured during the transfer in the acceleration driving of the motor) is different, there may be a limitation that the torque critical value for each driving has to be re-specified whenever the movement distance and/or movement speed of the end effector 110 are/is changed.

However, since the substrate transfer apparatus 100 according to the present invention compares the torque difference value D with the critical torque difference value to determine the collision of the end-effector 110, it may be possible to effectively detect the collision of the end-effector 110 that occurs in all drives (all of the acceleration driving of the motor, the constant speed driving of the motor, and the deceleration driving of the motor) with one critical torque difference value, and since the critical torque difference value is not significantly related to the maximum value of the torque value(s) of the motor 120 measured during the transfer in each driving, there may be no limitation (need) to set (or specify) the critical torque difference value whenever the moving distance and/or moving speed of the end effector 110 are/is changed.

In addition, the collision detection unit 130 may further include a reference value setting part 134 that sets a collision determination reference value. The reference value setting part 134 may set the collision determination reference value, and the collision determination reference value may be the critical torque difference value that indicates a sudden change in torque measurement value (or the current torque measurement value suddenly becomes much larger than the previous torque measurement value) rather than the torque critical value. For example, the reference value setting part 134 may experimentally (or empirically) measure an average value of the torque value (or values) of the motor 120 due to the collision of the end-effector 110 in advance and also appropriately set (or determine) the collision determination reference value between the torque value of the motor 120 due to the collision of the end-effector 110 measured in advance and the maximum value of the amount of change in the torque value (or the torque difference value) per unit time under normal conditions.

Thus, the collision determination part 133 may determine the collision of the end-effector 110 based on the torque difference value D, and if the torque difference value D is greater than or equal to the collision determination reference value, it may determine the collision of the end-effector 110, and if it is confirmed that the torque difference value D is greater than or equal to the critical torque difference value, it may determine the collision of the end-effector 110. When the collision of the end-effector 110 occurs, the currently measured torque measurement value may suddenly become (very) large, and thus, the torque difference value D may also suddenly become large and may be higher than the collision determination reference value (i.e., higher than the critical torque difference value). Thus, when the torque difference value D is greater than or equal to the collision determination reference value, the collision determination part 133 may recognize that the currently measured torque measurement value suddenly (significantly) increases to determine the collision of the end-effector 110.

Here, the control unit 140 may stop the driving of the motor 120 or drive the motor 120 in the reverse direction when the collision determination part 133 determines that the end-effector 110 has collided. When the collision determination part 133 determines that the end-effector 110 has collided, the control unit 140 may stop the driving of the motor 120 or drive the motor 120 in the reverse direction. The driving of the motor 120 may be stopped to reduce damage (e.g., damage to the substrate transfer apparatus and/or the collision target, or defects in the substrate) due to the collision of the end-effector 110, and the motor 120 may be driven in the reverse direction to minimize the damage due to the collision of the end-effector 110.

In addition, the collision detection unit 130 may further include a measurement position storage part 135 that records a measurement position of the torque value. The measurement position storage part 135 may record (or store) the measurement position of the torque value and may know at which position the torque value of the motor 120 was measured. For example, the position of the end-effector 110 (according to the driving of the motor) may be recorded as the measurement position of the torque value, and the measurement position of the torque value may be recorded as the rotation angle and/or rotation speed of each of the rotation shafts 21, 22, and 23.

As a result, the control unit 140 may stop the driving of the motor 120 after driving the motor 120 to a previously measured position (e.g., proximately measured position). When the collision determination part 133 determines that the end-effector 110 has collided, the control unit 140 may drive the motor 120 in the reverse direction, may adjust (or move) the position of the end-effector 110 or the rotation angle (or rotation speed) of each of the rotation shafts 21, 22, and 23 to the previously measured position by driving the motor 120 in the reverse direction, and may stop the driving of the motor 120 at the previously measured position. Here, the previously measured position may be the proximately measured measurement position, and the damage caused by the collision of the end-effector 110 may be confirmed (or inspected), and if the end-effector 110 is maintained at the previously measured position (i.e., the proximately measured position) or the damage caused by the collision of the end-effector 110 is minimized, the transfer (process) may be continued while measuring (or recording) the torque value of the motor 120 and the measurement position of the torque value (periodically) from the previously measured position.

Thus, the substrate transfer apparatus 100 according to the present invention may drive the motor 120 in the reverse direction to the previously measured position through the measurement position storage part 135 by the control unit 140, thereby facilitating maintenance while minimizing the damage caused by collision of the end-effector 110 and also confirming the damage caused by the collision of the end-effector 110 and/or improving the continuity of the transfer (process) after the maintenance.

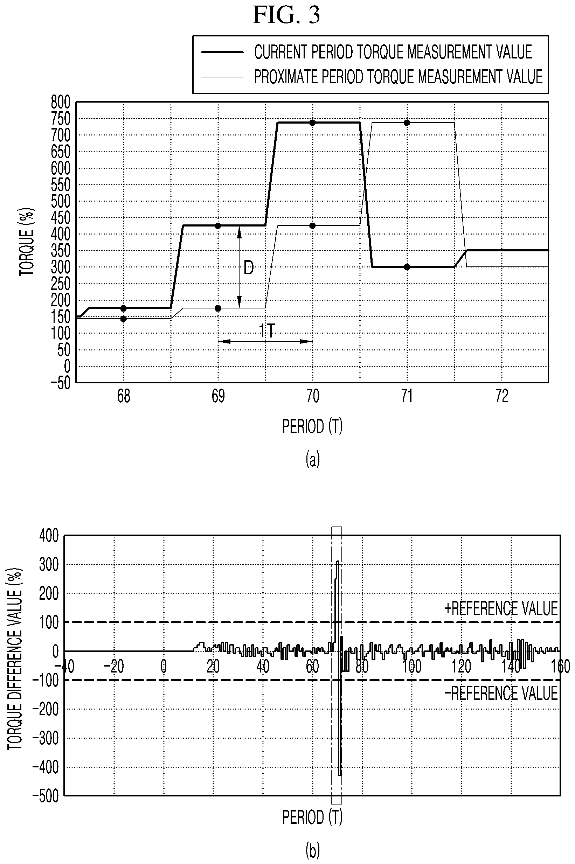

FIG. 3 is a conceptual view for explaining calculation of a torque difference value according to an embodiment of the present invention, (a) of FIG. 3 is a partially enlarged graph of the torque measurement value for each period and a proximate period torque measurement value for each value, and (b) of FIG. 3 is a graph illustrating a torque difference value between the torque measurement value for each period and the proximate period torque measurement value. Here, (a) of FIG. 3 is a graph that enlarges a portion indicated by the dashed dotted line box of FIG. 2, and the portion indicated as the dashed dotted line box of (b) of FIG. 3 illustrates a portion at which the collision of the end-effector occurred, in the same manner as the portion indicated by the dashed dotted line box of FIG. 2.

Referring to FIGS. 2 and 3, the torque measurement part 131 may measure the torque value of the motor 120 at a predetermined period T, and the difference value calculation part 132 may calculate the torque difference value D between the torque measurement value of a current period torque measurement value and a proximate period torque measurement value for each of the predetermined periods T. The torque measurement part 131 may measure the torque value of the motor 120 at a predetermined period T and may determine (or specify) a target (i.e., a torque measurement value measured at a different time) to be compared (or calculated) with the currently measured torque measurement value according to the predetermined period T. Here, the currently measured torque measurement value may be compared with the torque measurement value measured in a proximately period (or the proximate period torque measurement value), and the torque measurement value measured in the proximate period may be subtracted (or deducted) from the currently measured torque measurement value.

Here, the difference value calculation part 132 may calculate the torque difference value D between the current period torque measurement value (i.e., the currently measured torque measurement value) and the proximate period torque measurement value (i.e., the torque measurement value measured in the proximate period) for each of the predetermined periods T. Thus, the torque difference value D may be calculated in real time by measuring the current period torque measurement value in real time, and the collision of the end-effector 110 may be determined by comparing the torque difference value D calculated at each predetermined period T with the collision determination reference value. As a result, it is possible to detect (or determine) the collision of the end-effector 110 for the entire time for the transfer (process).

The collision detection unit 130 may further include a measurement value storage part 136 that stores the measured torque value of the motor 120. The measurement value storage part 136 may store the measured torque value of the motor 120, and may measure and record (or store) the current period torque measurement value in real time. Here, when the measured torque value of the motor 120 is stored in the measurement value storage part 136, the measured position of the torque value may be recorded in the measurement position storage part 135. This may allow the proximate period torque measurement value to be retrieved and compared (or calculated) with the current period torque measurement value. The measurement value storage part 136 may repeat storage (or writing) and update (or erasing), and in this case, storage capacity may be reduced, and a processing speed may increase.

When a stationary object is driven (or move) and then stopped again, the stationary object may be accelerated and then decelerated. For the stable driving (or movement), the object may be driven (or move) at a constant speed between the acceleration and the deceleration.

For this, the driving of the motor 120 may include acceleration driving in which the torque of the motor 120 increases, constant speed driving in which the torque of the motor 120 is maintained within a predetermined deviation, and deceleration driving in which the torque of the motor 120 decreases. In the acceleration driving, the rotation speed of the stationary end-effector 110 and/or the rotation shafts 21, 22, and 23 may be accelerated (or moves to be accelerated), and for this, the torque of the motor 120 may increase.

In the constant speed driving, the end-effector 110 may move (or rotates the rotation shaft) at a constant speed, and for this, the torque of the motor 120 may be maintained within a predetermined deviation.

In the deceleration driving, the rotation speed of the end-effector 110 and/or the rotation shafts 21, 22, and 23 may be decelerated (or move to be decelerated) to stop the end-effector 110 and/or the rotation shafts 21, 22, and 23, and for this, the torque of the motor 120 may be reduced.

Here, in the acceleration driving, since the torque of the motor 120 increases (largely), the torque difference value D between the current torque measurement value and the previous torque measurement value may increase. As the torque difference value D increases, the collision determination reference value may also increase, and when the collision determination reference value increases, sensitivity of the collision detection of the end-effector 110 may decrease. Particularly, in the constant speed driving, since the average value of the torque difference value D is close to '0' and very low, even if the torque difference value D increases due to the collision of the end-effector 110, it may not exceed the increasing collision determination reference value, and thus, even if the collision of the end-effector 110 occurs, the collision may not be detected.

The substrate transfer apparatus 100 according to the present invention may further include an acceleration time setting unit 150 that sets a time for the acceleration driving.

The acceleration time setting unit 150 may set the time for the acceleration driving and control the amount of change in torque value per unit time (or per period T) in the acceleration driving. For example, the acceleration time setting unit 150 may lower a maximum value of the change in torque value per unit time (or the torque difference value) in the acceleration driving by adjusting the time for the acceleration driving, thereby lowering the collision determination reference value determined according to the maximum value of the change in torque value per unit time.

Here, the amount of change (maximum value) of the torque value per unit time may be lowered as the maximum torque value in the acceleration driving is smaller, and the time for the acceleration driving is longer, and the time for the acceleration driving may be appropriately determined according to the movement distance of the end-effector **110.** If the movement distance of the end-effector 110 is shortened, the time for the acceleration driving may not but be shortened relatively, and the maximum torque value in the acceleration driving may also be reduced. On the other hand, if the movement distance of the end-effector 110 is sufficiently long, the maximum torque value in the acceleration driving may increase for smooth (or fast) transfer (process), and the time for the acceleration driving may be set (long) so that the amount of change (maximum value) of the torque value per unit time decreases according to the increasing maximum torque value in the acceleration driving.

Here, the reference value setting part 134 may set the collision determination reference value according to a rate of change (or amount of change) of the torque value of the motor 120 for the set acceleration driving time. If the rate of change in torque value of the motor 120 with respect to the set acceleration driving time (the amount of change in torque value of the motor/the set acceleration driving time) is large, the torque difference value D (or the amount of change in torque value per unit time) in the acceleration driving may become large, and thus, the collision determination reference value may be set to be large. Conversely, if the rate of change in torque value of the motor 120 with respect to the time for the acceleration driving that is set as described above is small, the torque difference value D in the acceleration driving may become small, and thus, the collision determination reference value may be set to be small. That is, the reference value setting part 134 may set the collision determination reference value in proportion to the rate of change in the torque value of the motor 120 with respect to the set acceleration driving time.

Here, since the maximum torque value in the acceleration driving is fixed (or determined) according to the movement distance of the end-effector 110 (experimentally or empirically), the collision determination reference value may be set according to the set time for the acceleration driving, and the maximum value of the change in torque value per unit time (in the acceleration driving) may be determined according to the set time for the acceleration driving. Since the collision determination reference value has to be greater than the maximum value of the change in torque value per unit time to prevent the collision of the end-effector 110 from being determined even if the collision of the end-effector 110 does not occur, the reference setting part 134 may set the collision determination reference value to be greater than the maximum value of the change in torque value per unit time according to the set acceleration driving time.

In addition, the collision detection unit 130 may further include a measurement period setting part 137 that sets the measurement period T of the torque value of the motor 120 according to the set acceleration driving time. The measurement period setting part 137 may set the measurement period T of the torque value of the motor 120 according to the set acceleration driving time, and thus, the torque value of the motor 120 may be measured at the set period (i.e., the predetermined period), and while measuring the torque value of the motor 120 at each set period T, the torque value may be compared with the proximate period torque measurement value, and the collision of the end-effector 110 may be detected (or determined) in real time.

For example, the measurement period setting part 137 may set the measurement period T of the torque value of the motor 120 to measure the torque value of the motor 120 at least once in the acceleration driving according to the set acceleration driving time and may set the measurement period T of the torque value of the motor 120 to measure the torque value of the motor 120 at least twice in the acceleration driving for the effective collision detection of the end-effector 110. In the acceleration driving, when the torque value of the motor 120 is measured for the first time, the firstly (or initially) measured torque value of the motor 120 may be compared (or calculated) with '0', and the measured torque value of the motor 120 may be equal to the torque difference value D.

Here, the measurement period setting part 137 may set the measurement period T of the torque value of the motor 120 to be shorter than the set acceleration driving time. To detect the collision of the end-effector 110 in the acceleration driving, the torque value of the motor 120 has to be measured at least once in the acceleration driving, and for this, the measurement period setting part 137 may set the measurement period T of the torque value of the motor 120 to be shorter than the set time for the acceleration driving. Thus, the collision of the end-effector 110 may be detected even in the acceleration driving, and the collision of the end-effector 110 occurring in all driving (the acceleration driving of the motor, the constant speed driving of the motor, and the deceleration driving of the motor) may be effectively detected.

For example, the measurement period setting part 137 may set the measurement period T of the torque value of the motor 120 to be as short as 4 milliseconds (ms) to 12 milliseconds (ms) and may set the measurement period T of the torque value of the motor 120 for a short time (e.g., 4 ms to 12 ms) in which no damage to the end-effector 110 and the substrate 10 are caused or minimized.

In addition, the torque measurement part 131 may measure the torque value of the motor 120 at least twice during the acceleration driving (section). If the torque value of the motor 120 is not measured even once during the acceleration driving (section), the collision of the end-effector 110 may not be detected during the acceleration driving (section), and if the torque value of the motor 120 is measured only once during the acceleration driving (section), the measured torque value of the motor 120 may be equal to the torque difference value D, and thus, the maximum value of the torque value of the motor 120 may increase, and the collision determination reference value may necessarily increase. When the collision determination reference value increases, the sensitivity of the collision detection of the end-effector 110 may decrease, and especially in the constant speed driving, the sensitivity of the collision detection of the end-effector 110 may decrease, and thus, in all driving (all of the acceleration driving of the motor, the constant speed driving of the motor, and the deceleration driving of the motor), the torque measurement part 131 may measure the torque value of the motor 120 at least twice in the acceleration driving (section) so that the sensitivity of the collision detection of the end-effector 110 is improved.

Here, the torque measurement part 131 may measure at least the torque value of the motor 120 at a starting point (or starting time) of the acceleration driving. The torque measurement part 131 may measure the torque value of the motor 120 at an origin point (or the starting point of the acceleration driving), may measure the torque value of the motor 120 at the origin point before starting the acceleration driving, and may also measure the torque value of the motor 120 at the origin point in the 0-period **T.** The torque value of the motor 120 measured at the starting point (or the origin point) of the acceleration driving may be compared (or calculated) with the torque value of the motor 120 measured initially during the acceleration driving, and the torque difference value D may be calculated by subtracting (or deducting) the torque value of the motor 120 measured at the starting point of the acceleration driving (or a 0-period torque measurement value) from the torque value of the motor 120 measured for the first time (or a **1-**period torque measurement value). Thus, even if only the torque value of the motor 120 in the 1-period T is measured in the acceleration driving, the torque difference value D may be calculated by subtracting (or deducting) the torque measurement value in the 0-period T (or the torque value of the motor measured at the starting point of the acceleration driving) from the torque measurement value in the 1-period T, thereby detecting the collision of the end-effector 110 in the acceleration driving.

The calculation of the torque measurement value in the 1-period T with the torque measurement value of the 0-period T may be performed in the difference value calculation part 132 and may also be performed in another configuration of the collision detection unit 130. Here, the 0-period T torque measurement value may not be '0', may be less than 0, and may be forcibly fixed to '0'. In the case of forcibly fixing to '0', the torque value of the motor 120 may not be measured directly (or practically) at the starting point of the acceleration driving, and the torque measurement value of the 1-period T may be calculated as the torque difference value D without calculation in the difference value calculation part 132.

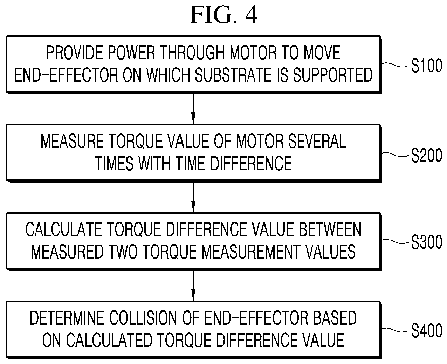

FIG. 4 is a flowchart illustrating an operation method of a substrate transfer apparatus according to another embodiment of the present invention.

Referring to FIG. 4, an operation method of a substrate transfer apparatus according to another embodiment of the present invention will be examined in more detail. However, any duplicated details with those described above in relation to the substrate transfer apparatus according to an embodiment of the present invention will be omitted.

The operation method of the substrate transfer apparatus according to another embodiment may include a process (S100) of moving an end-effector on which a substrate is supported by providing power through a motor, a process (S200) of measuring a torque value of the motor several times with a time difference, a process (S300) of calculating a torque difference value between two measured torque measurement values, and a process (S400) of determining collision of the end-effector based on the calculated torque difference value.

First, power is supplied through the motor to move the end-effector on which the substrate is supported (S100). The power may be provided through the motor to move the end-effector on which the substrate is supported, thereby transferring the substrate. Here, the control unit may control driving of the motor and control (or adjust) the movement of the end-effector.

Next, the torque value of the motor is measured several times with a time difference (S200). The torque value of the motor may be measured several times during the process of moving the end-effector, and the torque measurement part of the collision detection unit may measure the torque value of the motor several times with a time difference. For example, the torque measurement part may measure the torque value of the motor in each predetermined period.

Next, the torque difference between the two measured torque values is calculated (S300). The torque value of the motor may be measured several times to calculate the torque difference value between the two torque measurement values measured with a time difference, and the difference value calculation part of the collision detection unit may calculate the torque difference value between the two torque measurement values among the plurality of torque measurement values measured several times with the time difference. For example, the torque difference between the currently measured torque measurement value (or the current torque measurement value) and the torque measurement value (or the previous torque measurement value) measured in the previous period (before a predetermined time) may be calculated, and the torque difference value may be calculated in real time by subtracting (or deducting) the torque measurement value measured before a predetermined time (i.e., the previous torque measurement value) from the torque measurement value measured in real time (i.e., the current torque measurement value), and the torque difference value may also be expressed as an absolute value.

In addition, the collision of the end-effector is determined based on the calculated torque difference value (S400). The collision of the end-effector may be determined based on the calculated torque difference value, and a collision determination part of the collision detection unit may determine the collision of the end-effector based on the torque difference value, and when the torque difference value is greater than or equal to a critical torque difference value (or a collision determination reference value), it may be determined that the collision of the end-effector occurred. For example, the collision determination part may determine the collision of the end-effector by comparing the torque difference value obtained by subtracting (or deducting) the torque measurement value measured before the predetermined time from the torque measurement value measured in real time with the critical torque difference value, rather than comparing the torque measurement value measured in real time with the torque critical value.

The operation method of the substrate transfer apparatus according to the present invention may further include a process (S50) of setting a collision determination reference value, and a process (S400) of determining the collision of the end-effector, and if the collision of the end-effector is determined, a process (S500) of stopping the driving of the motor or driving the motor in the reverse direction.

The collision determination reference value may be set (S50). The reference value setting part may set the collision determination reference value, and the collision determination reference value may be the critical torque difference value that indicates a sudden change in torque measurement value (or the current torque measurement value suddenly becomes much larger than the previous torque measurement value) rather than the torque critical value. For example, the reference value setting part may experimentally (or empirically) measure an average value of the torque value (or values) of the motor due to the collision of the end-effector in advance and also appropriately set (or determine) the collision determination reference value between the torque value of the motor due to the collision of the end-effector measured in advance and the maximum value of the amount of change in the torque value (or the torque difference value) per unit time under normal conditions.

In addition, in the process (S400) of determining the collision of the end-effector, if the collision of the end-effector is determined, the driving of the motor may be stopped, or the motor may be driven in the reverse direction (S500). In the process (S400) of determining the collision of the end-effector, if the collision determination part determines that the collision of the end-effector is determined, the driving of the motor may be stopped, or the motor may be driven in the reverse direction. When the collision determination part determines that the end-effector has collided, the control unit may stop the driving of the motor or drive the motor in the reverse direction. The driving of the motor may be stopped to reduce damage (e.g., damage to the substrate transfer apparatus and/or the collision target, or defects in the substrate) due to the collision of the end-effector, and the motor may be driven in the reverse direction to minimize the damage due to the collision of the end-effector.

In the process (S400) of determining the collision of the end-effector, the collision of the end-effector may be determined if the calculated torque difference value is greater than or equal to the set collision determination reference value. In the process (S400) of determining the collision of the end-effector, the collision determination part may determine the collision of the end-effector based on the torque difference value, and if the torque difference value is greater than or equal to the set collision determination reference value, the collision of the end-effector may be determined, and if it is confirmed that the torque difference value is greater than or equal to the critical torque difference value, the collision of the end-effector may be determined. When the collision of the end-effector occurs, the currently measured torque measurement value may suddenly become (very) large, and thus, the torque difference value may also suddenly become large and may be higher than the collision determination reference value (i.e., higher than the critical torque difference value). Thus, when the torque difference value is greater than or equal to the collision determination reference value, the collision determination part may recognize that the currently measured torque measurement value suddenly (significantly) increases to determine the collision of the end-effector.

The operation method of the substrate transfer apparatus according to the present invention may further include a process (S250) of recording a measurement position of the torque value.

The measurement position of the torque value may be recorded (S250). The measurement position storage part of the above collision detection unit may record (or store) the measurement position of the torque value, and may know at which position the torque value of the motor 120 was measured. For example, the position of the end-effector (according to the driving of the motor) may be recorded as the measurement position of the torque value, and the measurement position of the torque value may be recorded as the rotation angle and/or rotation speed of each of the rotation shafts.

In addition, the process (S500) of stopping the driving of the motor or driving the motor in the reverse direction may include a process (S510) of stopping the driving of the motor after driving the motor to the previously measured position.

After driving the motor to the previously measured position, the driving of the motor may be stopped (S510). The control unit may stop the driving of the motor after driving the motor to the previously measured position **(e.g.,** the proximately measured position). When the collision determination part determines that the end-effector has collided, the control unit may drive the motor in the reverse direction, may adjust (or move) the position of the end-effector or the rotation angle (or rotation speed) of each of the rotation shafts to the previously measured position by driving the motor in the reverse direction, and may stop the driving of the motor at the previously measured position. Here, the previously measured position may be the proximately measured measurement position, and the damage caused by the collision of the end-effector may be confirmed (or inspected), and if the end-effector is maintained at the previously measured position (i.e., the proximately measured position) or the damage caused by the collision of the end-effector is minimized, the transfer (process) may be continued while measuring (or recording) the torque value of the motor and the measurement position of the torque value (periodically) from the previously measured position.

Thus, in the operation method of the substrate transfer apparatus according to the present invention, the motor may move in the reverse direction to the previously measured position through the measurement position storage part by the control unit to facilitate maintenance while minimizing the damage caused by collision of the end-effector and also confirm the damage caused by the collision of the end-effector and/or improve the continuity of the transfer (process) after the maintenance.

The operation method of the substrate transfer apparatus according to the present invention may further include a process (S240) of storing the measured torque value of the motor.

The measured torque value of the motor may be stored (S240). The measurement value storage part of the collision detection unit may store the measured torque value of the motor and may measure and record (or store) the torque measurement value in the current period in real time. Here, when the measured torque value of the motor is stored in the measurement value storage part, the measured position of the torque value may be recorded in the measurement position storage part. This may allow the proximate period torque measurement value to be retrieved and compared (or calculated) with the current period torque measurement value. The torque value of the motor stored in the measurement value storage part may be (periodically) updated. The measurement value storage part may repeat storage (or writing) and update (or erasing), and in this case, storage capacity may be reduced, and a processing speed may increase.

In the process (S200) of measuring the torque value of the motor, the torque value of the motor may be measured at a predetermined period, and in the process (S300) of calculating the torque difference value, the torque difference value between the torque measurement value of the current period torque measurement value of the proximate period torque measurement value may be calculated for each of the predetermined periods. In the process (S200) of measuring the torque value of the motor, the torque measurement part may measure the torque value of the motor at a predetermined period and may determine (or specify) a target **(i.e.,** a torque measurement value measured at a different time) to be compared (or calculated) with the currently measured torque measurement value according to the predetermined period. Here, the currently measured torque measurement value may be compared with the torque measurement value measured in a proximately period (or the proximate period torque measurement value), and the torque measurement value measured in the proximate period may be subtracted (or deducted) from the currently measured torque measurement value.

In addition, in the process (S300) of calculating the torque difference value, the difference value calculation part may calculate the torque difference value between the current period torque measurement value (i.e., the currently measured torque measurement value) and the proximate period torque measurement value (i.e., the torque measurement value measured in the proximate period) for each of the predetermined periods. Thus, the torque difference value may be calculated in real time by measuring the current period torque measurement value in real time, and the collision of the end-effector may be determined by comparing the torque difference value calculated at each predetermined period with the collision determination reference value. As a result, it is possible to detect (or determine) the collision of the end-effector for the entire time for the transfer (process).

The process (S100) for moving the end-effector may include an acceleration process (S110) of moving the end-effector by increasing in torque of the motor, a constant speed process (S120) of moving the end-effector by maintaining the torque of the motor within a predetermined deviation, and a deceleration process (S130) for moving the end-effector by decreasing in torque of the motor.

In the acceleration process (S110) of increasing in torque of the motor to move, the rotation speed of the stopped end-effector and/or the rotation shaft may accelerated (or moves to be accelerated), and for this, the torque of the motor may increase.

In the constant speed process (S120) of moving while maintaining the torque of the motor within a predetermined deviation, the end-effector may move (or rotates the rotation shaft) at a constant speed, and for this, the torque of the motor may be maintained within a predetermined deviation.

In the deceleration process (S130) of moving by reducing the torque of the motor, the end-effector and/or the rotation shaft may be decelerated (or move at a reduced speed) to stop the end-effector and/or the rotation shaft, and for this, the torque of the motor may be reduced.

Here, in the acceleration process (S110), since the torque of the motor increases (largely), the torque difference value between the current torque measurement value and the previous torque measurement value may increase. As the torque difference value increases, the collision determination reference value may also increase, and when the collision determination reference value increases, sensitivity of the collision detection of the end-effector may decrease. Particularly, in the constant speed driving, since the average value of the torque difference value is close to '0' and very low, even if the torque difference value increases due to the collision of the end-effector, it may not exceed the increasing collision determination reference value, and thus, even if the collision of the end-effector occurs, the collision may not be detected.

The operation method of the substrate transfer apparatus according to the present invention may further include a process (S40) of setting a time for the acceleration process (S110).

The time for the acceleration process (S110) may be set (S40). The acceleration time setting unit may set the time for the acceleration process (S110) and may control the amount of change in torque value per unit time (or per period T) in the acceleration process (S110). For example, the acceleration time setting unit may lower a maximum value of the change in torque value per unit time (or the torque difference value) in the acceleration process (S110) by adjusting the time for the acceleration process (S110), thereby lowering the collision determination reference value determined according to the maximum value of the change in torque value per unit time.

Here, the amount of change (maximum value) of the torque value per unit time may be lowered as the maximum torque value in the acceleration process (S110) is smaller, and the time of the acceleration process (S110) is longer, and the time of the acceleration process (S110) may be appropriately determined according to the movement distance of the end-effector. If the movement distance of the end-effector 110 is shortened, the time for the acceleration process (S110) may not but be shortened relatively, and the maximum torque value in the acceleration process (S110) may also be reduced. On the other hand, if the movement distance of the end-effector is sufficiently long, the maximum torque value in the acceleration process (S110) may increase for smooth (or fast) transfer (process), and the time for the acceleration process (S110) may be set (long) so that the amount of change (maximum value) of the torque value per unit time decreases according to the increasing maximum torque value in the acceleration process (S110).

Here, in the process (S50) of setting the reference value, the collision determination reference value may be set according to a rate of change (or amount of change) of the torque value of the motor with respect to the set time for the acceleration process (S110). If the rate of change in torque value of the motor with respect to the set time for the acceleration process (S110) (the amount of change in torque value of the motor/the set time for the acceleration process) is large, the torque difference value (or the amount of change in torque value per unit time) in the acceleration process (S110) may become large, and thus, the collision determination reference value may be set to be large. Conversely, if the rate of change in torque value of the motor with respect to the set time for the acceleration process (S110) is small, the torque difference value in the acceleration process (S110) may become small, and thus the collision determination reference value may be set to be small. That is, the reference value setting part may set the collision determination reference value in proportion to (according to) the rate of change in the torque value of the motor with respect to the set time of the acceleration process (S110).

Here, since the maximum torque value in the acceleration process (S110) is fixed (or determined) according to the movement distance of the end-effector (experimentally or empirically), the collision determination reference value may be set according to the set time of the acceleration process (S110), and the maximum value of the change in torque value per unit time (in the acceleration driving) may be determined according to the set time for the acceleration process (S110). Since the collision determination reference value has to be greater than the maximum value of the change in torque value per unit time to prevent the collision of the end-effector from being determined even if the collision of the end-effector does not occur, in the process (S50) of setting the reference value, the reference setting part may set the collision determination reference value to be greater than the maximum value of the change in torque value per unit time according to the set time of the acceleration process (S110).

The operation method of the substrate transfer apparatus according to the present invention may further include a process (S45) of setting a measurement period of the torque value of the motor according to the set time for the acceleration process (S110).

The measurement period of the torque value of the motor may be set according to the time for the set acceleration process (S110) (S45). The measurement period setting part 137 of the collision detection unit may set the measurement period of the torque value of the motor according to the set time of the acceleration process (S110), and thus, the torque value of the motor may be measured at the set period (i.e., the predetermined period), and while measuring the torque value of the motor at each set period, the torque value may be compared with the proximate period torque measurement value, and the collision of the end-effector may be detected (or determined) in real time.

For example, the measurement period setting part may set the measurement period of the torque value of the motor to measure the torque value of the motor at least once in the acceleration process (S110) according to the set time of the acceleration process (S110) and may set the measurement period of the torque value of the motor to measure the torque value of the motor at least twice for effective collision detection of the end-effector in the acceleration process (S110). In the acceleration process (S110), when the torque value of the motor is measured for the first time, the firstly (or initially) measured torque value of the motor may be compared (or calculated) with '0', and the measured torque value of the motor may be equal to the torque difference value.

In the process (S45) of setting the measurement period, the measurement period of the torque value of the motor may be set shorter than the set time for the acceleration process (S110). In the process (S45) of setting the measurement period, the measurement period setting part may set the measurement period of the torque value of the motor to be shorter than the set time for the acceleration process (S110). To detect the collision of the end-effector in the acceleration process (S110), the torque value of the motor has to be measured at least once in the acceleration process (S110), and for this, the measurement period setting part may set the measurement period of the torque value of the motor to be shorter than the set time of the acceleration process (S110). Thus, it is possible to detect the collision of the end-effector even in the acceleration process (S110) and to effectively detect the collision of the end-effector that occurs in the process (S100) of moving the end-effector (or the entire moving process of the end-effector including the acceleration process, the constant speed process, and the deceleration process).

For example, the measurement period setting part may set the measurement period of the torque value of the motor to be as short as 4 milliseconds (ms) to 12 milliseconds (ms) and may set the measurement period of the torque value of the motor to a short time (e.g., 4 ms to 12 ms) in which the damage to the end-effector and the substrate does not occur or is minimized.

In the process (S200) of measuring the torque value of the motor, the torque value of the motor may be measured at least twice in the acceleration process (S110). In the process (S200) of measuring the torque value of the motor, the torque measurement part may measure the torque value of the motor at least twice during the acceleration process (S110). If the torque value of the motor is not measured even once during the acceleration process (S110), the collision of the end-effector may not be detected during the acceleration process (S110), and if the torque value of the motor is measured only once during the acceleration process (S110), the measured torque value of the motor may be equal to the torque difference value, and thus, the maximum value of the torque value of the motor may increase, and the collision determination reference value may necessarily increase. When the collision determination reference value increases, sensitivity of the collision detection of the end-effector may decrease, and particularly, the sensitivity of the collision detection of the end-effector may decrease during the constant speed process (S120). Thus, to improve the sensitivity of the collision detection of the end-effector during the entire movement process of the end-effector (all of the acceleration process, the constant speed process, and the deceleration process), the torque measurement part may measure the torque value of the motor at least twice during the acceleration process (S110).

In the process (S200) of measuring the torque value of the motor, the torque value of the motor may be measured at least at the starting point (or starting time) of the acceleration process (S110). In the process (S200) of measuring the torque value of the motor, the torque measurement part may measure the torque value of the motor at least at the starting point (or origin point) of the acceleration process (S110). The torque measurement part may measure the torque value of the motor at the origin point (or the starting point of the acceleration process), may measure the torque value of the motor at the origin point before starting the acceleration process (S110), and may also measure the torque value of the motor at the origin point in the 0-period (or the starting point of the acceleration process). The torque value of the motor measured at the starting point (or the origin point) of the acceleration process (S110) may be compared (or calculated) with the torque value of the motor measured initially when the end-effector starts moving in the acceleration process (S110), and the torque difference value may be calculated by subtracting (or deducting) the torque value of the motor measured at the starting point of the acceleration process (S110) (or the 0-period torque measurement value) from the torque value of the motor measured for the first time (or the 1-period torque measurement value). Thus, even if only the torque value of the motor in the 1-period is measured in the acceleration process (S110), the collision of the end-effector may be detected in the acceleration process (S110) by calculating the torque difference value by subtracting (or deducting) the 0-period torque measurement value (or the torque value of the motor measured at the starting point of the acceleration process) from the 1-period torque measurement value.

As described above, in the present invention, the torque difference value between the two torque measurement values measured with a time difference may be calculated through the collision detection unit, and the collision of the end-effector may be determined based on the torque difference value to effectively detect the collision of the end-effector, thereby minimizing the damage caused by the collision of the end-effector by stopping the motor or rotating the motor in the reverse direction. That is, the collision of the end-effector may be determined using the change in torque over time through the two torque measurement values measured with the time difference rather than the absolute amount of the torque to detect the collision of the end-effector regardless of the movement speed and movement distance of the end-effector and also effectively detect the collision of the end-effector both the case, in which the end-effector is moving while being accelerated or decelerated and the case, in which the end-effector is moving at the constant speed so that there is no need to differentiate the collision determination reference that is segmented according to the movement speed and movement distance of the end-effector.

Although preferred embodiments of the present invention have been described with reference to a number of illustrative embodiments thereof, the embodiments of the present invention are not limited to the foregoing embodiments, and thus, it should be understood that numerous other modifications and embodiments may be devised by those skilled in the art that will fall within the spirit and scope of the principles of this disclosure. Hence, the real protective scope of the present invention shall be determined by the technical scope of the accompanying claims.

## Claims

1. A substrate transfer apparatus comprising:
an end-effector on which a substrate is supported;
a motor configured to provide power for movement of the end-effector;
a collision detection unit configured to detect collision of the end-effector; and
a control unit configured to control driving of the motor depending on the collision detection of the collision detection unit,
wherein the collision detection unit comprises:
a torque measurement part configured to measure a torque value of the motor;
a difference value calculation part configured to calculate a torque difference value between two torque measurement values measured with a time difference; and
a collision determination part configured to determine the collision of the end-effector based on the torque difference value.

2. The substrate transfer apparatus of claim 1, wherein the collision detection unit further comprises a reference value setting part configured to set a collision determination reference value,
wherein the collision determination part is configured to determine that the end-effector has collided when the torque difference value is equal to or greater than the collision determination reference value, and
the control unit is configured to stop the driving of the motor or drive the motor in a reverse direction when the collision determination part determines that the end-effector has collided.

3. The substrate transfer apparatus of claim 2, wherein the collision detection unit further comprises a measurement position storage part configured to record a measurement position of the torque value,
wherein the control unit is configured to stop the driving of the motor after driving the motor to a previous measurement position.

4. The substrate transfer apparatus of claim **1,** wherein the collision detection unit further comprises a measurement value storage part configured to store the measured torque value of the motor,
wherein the torque measurement part is configured to measure the torque value of the motor at a predetermined period, and
the difference value calculation part is configured to calculate a torque difference value between a current period torque measurement value and a proximate period torque measurement value for each of the predetermined periods.

5. The substrate transfer apparatus of claim 2, wherein the driving of the motor comprises:
acceleration driving for increasing in torque of the motor;
constant speed driving for maintaining the torque of the motor within a predetermined deviation; and
deceleration driving for decreasing in torque of the motor,
wherein the substrate transfer apparatus further comprises an acceleration time setting unit configured to set an acceleration driving time.

6. The substrate transfer apparatus of claim 5, wherein the reference value setting part is configured to set the collision determination reference value depending on a rate of change in the torque value of the motor with respect to the set acceleration driving time.

7. The substrate transfer apparatus of claim 5, wherein the collision detection unit further comprises a measurement period setting part configured to set a measurement period of the torque value of the motor according to the set acceleration driving time,
wherein the measurement period setting part is configured to set the measurement period of the torque value of the motor to be shorter than the set acceleration driving time.

8. The substrate transfer apparatus of claim 5, wherein the torque measurement part is configured to measure the torque value of the motor at least twice during the acceleration driving.

9. The substrate transfer apparatus of claim 5, wherein the torque measurement part is configured to measure the torque value of the motor at least at a starting point of the acceleration driving.

10. An operation method of a substrate transfer apparatus, the operation method comprising:
moving an end-effector on which a substrate is supported by providing power through a motor;
measuring a torque value of the motor several times with a time difference;
calculating a torque difference value between two measured torque measurement values; and
determining collision of the end-effector based on the calculated torque difference value.

11. The operation method of claim 10, further comprising:
setting a collision determination reference value; and
stopping the driving of the motor or driving the motor in a reverse direction when it is determined that the end-effector has collided in the determining the collision of the end-effector,
wherein, in the determining the collision of the end-effector, it is determined that the end-effector has collided when the calculated torque difference value is equal to or greater than the set collision determination reference value.

12. The operation method of claim 11, further comprising recording a measurement position of the torque value,
wherein the stopping the driving of the motor or the driving the motor in the reverse direction comprises stopping the driving of the motor after driving the motor to a previous measurement position.

13. The operation method of claim 10, further comprising storing the measured torque value of the motor,
wherein, in the measuring the torque value of the motor, the torque value of the motor is measured at a predetermined period, and
in the calculating the torque difference value, a torque difference value between a current period torque measurement value and a proximate period torque measurement value is measured for each of the predetermined periods.

14. The operation method of claim 11, wherein the moving the end-effector comprises:
an acceleration process of increasing in torque of the motor;
a constant speed process of maintaining the torque of the motor within a predetermined deviation; and
a deceleration process of decreasing in torque of the motor,
wherein the operation method further comprises setting a time for the acceleration process.

15. The operation method of claim 14, wherein, in the setting the reference value, the collision determination reference value is set depending on a rate of change in the torque value of the motor with respect to the set time of the acceleration process.

16. The operation method of claim 14, further comprising setting a measurement period of the torque value of the motor according to the set time of the acceleration process,
wherein, in the setting the measurement period, the measurement period of the torque value of the motor is set to be shorter than the set time of the acceleration process.

17. The operation method of claim 14, wherein, in the measuring the torque value of the motor, the torque value of the motor is measured at least twice in the acceleration process.

18. The operation method of claim 14, wherein, in the measuring the torque value of the motor, the torque value of the motor is measured at least at a starting point in the acceleration process.
